# EUROPÄISCHE PATENTANMELDUNG

(11) **EP 0 911 872 A2**
(43) Veröffentlichungstag der Anmeldung: **28.04.1999**
(21) Anmeldenummer: 98119277.6
(22) Anmeldetag: 13.10.1998
(51) Int. Cl.: H01L 21/336

(54) **Verfahren zur Herstellung von Dünnschichttransistoren**

(30) Priorität: 24.10.1997 DE 19746961
(71) Anmelder: Lüder, Ernst, Prof. Dr.-Ing. habil., D-70550 Stuttgart (DE)
(72) Erfinder: Maier, Gert, 72770 Reutlingen (DE); Ullmann, Jörg, 73033 Göppingen (DE); Lüder, Ernst, 70192 Stuttgart (DE)
(74) Vertreter: Möbus, Daniela, Dr.-Ing.

(57) **Zusammenfassung**

Ein Verfahren zur Herstellung von Dünnschichttransistoren mit amorphem Silizium als Halbleitermaterial, wobei das amorphe Silizium durch Ionenimplantation durch die Metallschicht für die Drain- und Source-Kontakte hindurch dotiert wird.

## Beschreibung

Die Erfindung betrifft ein Verfahren zur Herstellung von Dünnschichttransistoren mit amorphem Silizium als Halbleitermaterial.

Diese Dünnschichttransistoren werden in erster Linie zur Ansteuerung der Zellen von Flüssigkristall-Bildschirmen eingesetzt. Zu ihrer Herstellung sind bisher verschiedene Verfahren bekannt. Beim sogenannten "Back Channel Etch Process" wird nach dem Abscheiden und Strukturieren eines Metalls als Gate eine Schichtfolge aus einem Gate-Isolator, intrinsischem amorphen Silizium, dotiertem amorphen Silizium und Metall abgeschieden. Anschließend wird die Metallschicht für die Drain- und Source-Anschlüsse strukturiert. Dann folgt mit der gleichen Maske wie für die Strukturierung der Metallschicht die Strukturierung des dotierten amorphen Siliziums. In einem letzten Maskenprozeß wird das intrisische amorphe Silizium strukturiert. Dieses bekannte Verfahren hat den Nachteil, daß die Strukturierung des dotierten amorphen Siliziums Probleme bietet, da es nicht selektiv zum darunterliegenden intrinsischen amorphen Silizium geätzt werden kann. Aus diesem Grund muß eine relativ dicke intrinsische amorphe Siliziumschicht vorgesehen werden, wodurch jedoch die Lichtempfindlichkeit sowie die Sperrströme des Dünnschichttransistors erhöht werden.

Ein weiterer Prozeß, bei dem dotiertes amorphes Silizium für die Drain- und Source-Kontakte abgeschieden wird, stellt der sogenannte "Etching-Stopper-Process" dar. Nach diesem Verfahren wird zunächst eine Metallschicht als Gate-Kontakt abgeschieden und strukturiert. Anschließend werden in einem PECVD-System nacheinander ein Gate-Isolator, amorphes Silizium sowie eine Ätzstoppschicht abgeschieden und anschließend die Ätzstoppschicht in einem Maskenprozeß strukturiert. Danach wird das Oberflächenoxid, das sich über der Struktur gebildet hat, entfernt, bevor dotiertes amorphes Silizium abgeschieden wird. Es folgt dann die Abscheidung und Strukturierung einer weiteren Metallschicht für die Drain- und Source-Anschlüsse. Die Metallschicht dient zusammen mit der Ätzstoppschicht als Maske bei der anschließenden Strukturierung der dotierten und undotierten Siliziumschichten. Bei diesem Prozeß ist als nachteilig anzusehen, daß die Entfernung des Oberflächenoxids vor Aufbringen der dotierten Siliziumschicht nur unter Verwendung von verdünnter Flußsäure durchgeführt werden kann. Der Umgang mit Flußsäure ist jedoch sehr gefährlich, da diese Substanz auch sehr giftig ist. Außerdem ist die Reproduzierbarkeit dieses Prozeßschrittes sehr schwierig, so daß mit hohen Ausbeuteschwankungen bei der Transistorfertigung gerechnet werden muß.

Neben den beiden beschriebenen Standardprozessen zur Herstellung von Dünnschichttransistoren mit amorphem Silizium als Halbleiter ist in "An a-Si:H TFT with n⁺ Ion Doped Region", S. Ishihara et al., SID 93 DIGEST, Seiten 459 - 462 ein Verfahren vorgeschlagen worden, bei dem die dotierte amorphe Siliziumschicht durch lonenimplantation in eine amorphe Siliziumschicht erzeugt wird. Nach dem Aufbringen und Strukturieren einer Metallschicht für das Gate wird ein Gate-Isolator, eine amorphe Siliziumschicht und eine Ätzstoppschicht aufgebracht. Anschließend wird die Ätzstoppschicht strukturiert, bevor die amorphe Siliziumschicht durch Ionenstrahlimplantation von Phosphor-Ionen dotiert wird. Die Ätzstoppschicht wirkt dabei als Implantierschutz für den Halbleiterkanal. Anschließend wird eine weitere Metallschicht für die Drain- und Source-Anschlüsse abgeschieden und strukturiert. Die Metallschicht dient dann gemeinsam mit der strukturierten Ätzstoppschicht als Maske zur Strukturierung der dotierten amorphen Siliziumschicht. Bei der Implantation entsteht jedoch eine Verteilung des Phosphors, die im Bereich der Oberfläche der Siliziumschicht ein Minimum aufweist. Hierdurch ist der elektrische Kontakt zu den darüber angeordneten metallischen Drain- und Source-Anschlüssen relativ schlecht. Dieses Problem läßt sich nur dadurch vermeiden, daß ein Teil der Oberfläche der dotierten Siliziumschicht abgeätzt wird. Doch auch dieser Ätzschritt weist eine schlechte Reproduzierbarkeit auf. Es handelt sich bei diesem Verfahren daher auch nicht um einen Standardprozeß zur Herstellung von Dünnschichttransistoren.

Der vorliegenden Erfindung liegt die Aufgabe zugrunde, ein Verfahren zur Herstellung von Dünnschichttransistoren mit amorphem Silizium als Halbleiter zu schaffen, das die Nachteile der bekannten Verfahren vermeidet.

Die Aufgabe wird mit einem Verfahren gelöst, das gekennzeichnet ist durch die Prozeßschritte:
- Aufbringen einer ersten elektrisch leitfähigen Schicht auf ein Substrat und Strukturieren als Gate-Kontakt des Transistors,
- Aufbringen eines Gate-Isolators,
- Aufbringen von amorphem Silizium,
- Aufbringen und Strukturieren einer Ätzstoppschicht,
- Aufbringen einer zweiten elektrisch leitfähigen Schicht für die Drain- und Source-Anschlüsse,
- Ionenstrahlimplantation durch die zweite elektrisch leitfähige Schicht hindurch in die amorphe Siliziumschicht mit der Ätzstoppschicht als Implantierschutzschicht für den Halbleiterkanal,
- Strukturieren der zweiten elektrisch leitfähigen Schicht als Drain- und Source-Kontakte,
- Strukturieren der implantierten amorphen Siliziumschicht mit der zweiten elektrisch leitfähigen Schicht und der Ätzstoppschicht als Maske.

Das erfindungsgemäße Verfahren zeichnet sich also dadurch aus, daß die Ionenimplantation durch die zweite elektrisch leitfähige Schicht hindurch erfolgt. Dadurch ist es möglich, das Maximum der Ionenkonzentration an der Grenzfläche der Halbleiterschicht zur elektrisch leitfähigen Schicht zu plazieren. Der Ohmsche Kontakt zwischen der zweiten elektrisch leitfähigen Schicht und der dotierten Halbleiterschicht wird dadurch sehr gut. Die Halbleiterschicht kann sehr dünn gewählt werden, was eine Verbesserung der Eigenschaften der Transistoren, insbesondere hinsichtlich geringer Lichtempfindlichkeit und geringeren Sperrströmen, bewirkt. Die Oxidation der Halbleiteroberfläche wirkt bei diesem Verfahren nicht störend, so daß das Oberflächenoxid nicht entfernt zu werden braucht. Dadurch ist auch die Reproduzierbarkeit des Prozesses sehr hoch, wodurch sich eine konstante hohe Ausbeute an fehlerfreien Transistoren erzielen läßt. Außerdem erhalten die Transistoren sehr gute elektrische Eigenschaften in Bezug auf Beweglichkeit, Schwellspannung und Sperrstrom. Zur Erniedrigung des elektrischen Widerstands kann nach der Ionenstrahlimplantation auch eine weitere elektrisch leitfähige Schicht aufgebracht werden. Vorzugsweise können Phosphor-Atome in die amorphe Siliziumschicht implantiert werden. Als Gate-Isolator und auch als Ätzstoppschicht kann vorzugsweise Siliziumnitrid aufgebracht werden. Dann läßt sich die Abscheidung des Gate-Isolators, des amorphen Siliziums und der Ätzstoppschicht ohne Unterbrechung des Vakuums in einem PECVD-System durchführen. Für die elektrisch leitfähigen Schichten lassen sich zweckmäßigerweise Metalle verwenden.

Die Erfindung umfaßt auch einen Dünnschichttransistor, der nach einem erfindungsgemäßen Verfahren hergestellt ist und eine durch Ionenimplantation dotierte amorphe Siliziumschicht aufweist. Dabei kann das Maximum der Dotierungsverteilung in der Siliziumschicht vorzugsweise an der Oberfläche der Schicht liegen. Ein bevorzugtes Einsatzgebiet der erfindungsgemäßen Dünnschichttransistoren ist die Ansteuerung der Bildpunkte eines Flüssigkristalldisplays.

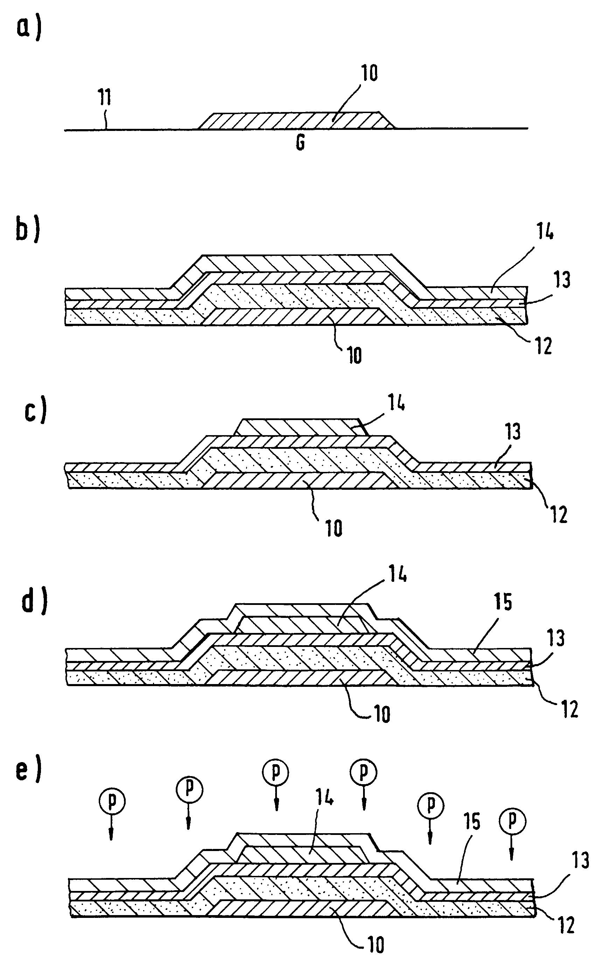

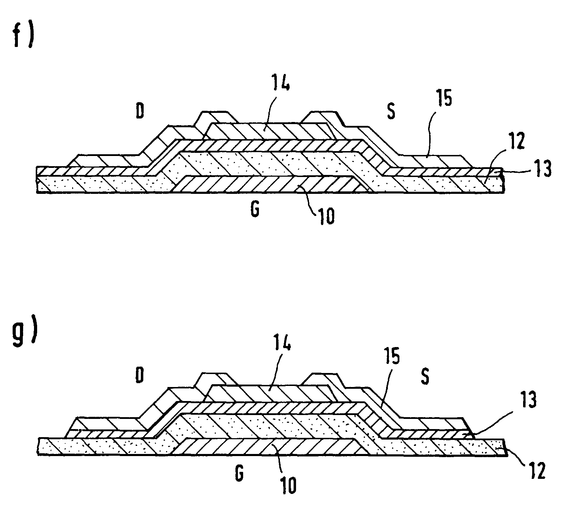

Nachfolgend wird ein erfindungsgemäßes Verfahren anhand der Zeichnung näher beschrieben.

Die einzige Figur zeigt einen Querschnitt durch einen Dünnschichttransistor in verschiedenen Stadien der Herstellung. In Schritt a) ist das Abscheiden einer leitfähigen Schicht 10 auf ein Glassubstrat 11 und die Strukturierung dieser Schicht 10 als Gate G des Transistors gezeigt. In Schritt b) werden nacheinander auf die Schicht 10 ein Gate-Isolator 12, amorphes Silizium 13 und eine Ätzstoppschicht 14 in einem PECVD-Verfahren abgeschieden, wobei der Gate-Isolator und die Ätzstoppschicht vorzugsweise aus Siliziumnitrid bestehen können. In Schritt c) ist die Strukturierung der Ätzstoppschicht 14 gezeigt. Anschließend wird in Schritt d) eine zweite elektrisch leitfähige Schicht 15, vorzugsweise ein Metall, ganzflächig aufgebracht, bevor in Schritt e) durch Ionenstrahlimplantation von Phosphor-Atomen P die intrinsische amorphe Siliziumschicht 13 durch die zweite leitfähige Schicht 15 hindurch dotiert wird, wobei die Ätzstoppschicht 14 als Implantationssperre dient, so daß der den Halbleiterkanal bildende Bereich der Halbleiterschicht 13 unterhalb der Ätzstoppschicht 14 nicht dotiert wird. Die Ionenstrahlimplantation kann vorzugsweise mit einer Energie von 20 - 30 keV und in einer Dosis von ca. 1E15 cm³ - 1E16 cm³ erfolgen. Nach dem Implantationsschritt e) wird im Schritt f) die zweite elektrisch leitfähige Schicht 15 als Drain und Source D, S strukturiert. Im letzten Schritt g) wird dann die dotierte amorphe Siliziumschicht 13 mit der Ätzstoppschicht 14 und der elektrisch leitfähigen Schicht 15 als Maske strukturiert und somit der Transistor fertiggestellt.

## Patentansprüche

1. Verfahren zur Herstellung von Dünnschichttransistoren mit amorphem Silizium als Halbleitermaterial, gekennzeichnet durch die Prozeßschritte:
- Aufbringen einer ersten elektrisch leitfähigen Schicht (10) auf ein Substrat (11) und Strukturieren als Gate-Kontakt (G) des Transistors,
- Aufbringen eines Gate-Isolators (12),
- Aufbringen von amorphem Silizium (13),
- Aufbringen und Strukturieren einer Ätzstoppschicht (14),
- Aufbringen einer zweiten elektrisch leitfähigen Schicht (15) für die Drain- und Source-Anschlüsse (D, S),
- Ionenstrahlimplantation durch die zweite elektrisch leitfähige Schicht (15) hindurch in die amorphe Siliziumschicht (13) mit der Ätzstoppschicht (14) als Implantierschutzschicht für den Halbleiterkanal,
- Strukturieren der zweiten elektrisch leitfähigen Schicht (15) als Drain- und Source-Kontakte (D, S),
- Strukturieren der implantierten amorphen Siliziumschicht (13) mit der zweiten elektrisch leitfähigen Schicht (15) und der Ätzstoppschicht (14) als Maske.

2. Verfahren nach Anspruch 1, dadurch gekennzeichnet, daß nach der Ionenstrahlimplantation eine weitere elektrisch leitfähige Schicht zur Erniedrigung des elektrischen Widerstands aufgebracht wird.

3. Verfahren nach Anspruch 1 oder 2, dadurch gekennzeichnet, daß Phosphor-Atome in die amorphe Siliziumschicht (13) implantiert werden.

4. Verfahren nach einem der Ansprüche 1 bis 3, dadurch gekennzeichnet, daß als Gate-Isolator (12) Siliziumnitrid aufgebracht wird.

5. Verfahren nach einem der Ansprüche 1 bis 4, dadurch gekennzeichnet, daß als Ätzstoppschicht (14) Siliziumnitrid aufgebracht wird.

6. Verfahren nach einem der Ansprüche 1 bis 5, dadurch gekennzeichnet, daß die Abscheidung des Gate-Isolators (12), des amorphen Siliziums (13) und der Ätzstoppschicht (14) ohne Unterbrechung des Vakuums in einem PECVD-System erfolgt.

7. Verfahren nach einem der Ansprüche 1 bis 6, dadurch gekennzeichnet, daß für die elektrisch leitfähigen Schichten (10, 15) Metalle aufgebracht werden.

8. Dünnschichttransistor, hergestellt nach einem der Verfahren der Ansprüche 1 bis 6, mit einer durch Ionenimplantation dotierten amorphen Siliziumschicht (13).

9. Dünnschichttransistor nach Anspruch 8, dadurch gekennzeichnet, daß das Maximum der Dotierungsverteilung in der Siliziumschicht (13) an der Oberfläche der Schicht liegt.
